(19) Europäisches Patentamt / European Patent Office / Office européen des brevets

(11) **EP 2 136 415 A1**

(12) **EUROPEAN PATENT APPLICATION**
published in accordance with Art. 153(4) EPC

(43) Date of publication:
**23.12.2009 Bulletin 2009/52**

(51) Int Cl.:
*H01L 35/22* (2006.01)   *C01G 33/00* (2006.01)
*C04B 35/00* (2006.01)   *C04B 41/87* (2006.01)
*H01L 35/34* (2006.01)

(21) Application number: **08740527.0**

(22) Date of filing: **10.04.2008**

(86) International application number:
**PCT/JP2008/057457**

(87) International publication number:
**WO 2008/133153 (06.11.2008 Gazette 2008/45)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **12.04.2007 JP 2007104643**

(71) Applicant: **Sumitomo Chemical Company, Limited Tokyo 104-8260 (JP)**

(72) Inventors:
• **TOHMA, Tetsuro**
 **Niihama-shi**
 **Ehime 792-0009 (JP)**
• **SADAOKA, Kazuo**
 **Toyonaka-shi**
 **Osaka (JP)**
• **UCHIDA, Yoshio**
 **Moriya-shi**
 **Ibaraki 302-0115 (JP)**

(74) Representative: **Hart-Davis, Jason et al**
 **Cabinet Beau de Loménie**
 **158, rue de l'Université**
 **75340 Paris Cedex 07 (FR)**

(54) **THERMOELECTRIC CONVERSION MATERIAL, METHOD FOR PRODUCTION THEREOF, AND THERMOELECTRIC CONVERSION ELEMENT**

(57)   The present invention provides thermoelectric conversion materials, method for producing the same, and thermoelectric conversion device. The thermoelectric conversion material comprises an oxide represented by formula (1) : $M^1O_y$ (1), where $M^1$ is at least one selected from the group consisting of V, Nb and Ta, and $1.90 \leq y \leq 2.10$.

Fig. 2

EP 2 136 415 A1

**Description**

TECHNICAL FIELD

The present invention relates to a thermoelectric conversion material, a method for producing the same, and a thermoelectric conversion device.

BACKGROUND ART

Thermoelectric conversion electric power generation is power generation achieved by converting thermal energy into electric energy by a phenomenon in which a voltage (thermoelectromotive force) is generated when a temperature difference is established across a thermoelectric conversion material, that is, Seebeck effect. Since thermoelectric conversion electric power generation can use various kinds of waste heat, such as geothermal heat and heat of incinerators, as heat source, this electric power generation is expected as environmentally friendly electric power generation that can be put into practical use.

The energy conversion efficiency of a thermoelectric conversion material depends on the figure of merit Z of the thermoelectric conversion material. The figure of merit Z is calculated from the following equation using the Seebeck coefficient $\alpha$, the electric conductivity $\sigma$ and the thermal conductivity $\kappa$ of the material. As the figure of merit Z of the thermoelectric conversion material is larger, the energy conversion efficiency thereof becomes higher. In particular, $\alpha^2 \times \sigma$ in the equation is referred to as an output factor. As the output factor of the thermoelectric conversion material is larger, the output per unit temperature of a thermoelectric conversion device becomes higher.

$$Z = \alpha^2 \times \sigma / \kappa$$

The thermoelectric conversion material is either a p-type thermoelectric conversion material having a positive Seebeck coefficient or an n-type thermoelectric conversion material having a negative Seebeck coefficient. Usually, a thermoelectric conversion device in which a p-type thermoelectric conversion material and an n-type thermoelectric conversion material are electrically connected in series is used for thermoelectric conversion electric power generation. The energy conversion efficiency of the thermoelectric conversion device depends on the figure of merit Z of the p-type thermoelectric conversion material and the figure of merit Z of the n-type thermoelectric conversion material. A p-type thermoelectric conversion material and an n-type, thermoelectric conversion material, each having a large figure of merit Z, are required to obtain a thermoelectric conversion device having excellent energy conversion efficiency.

For example, JP-A-2005-276959 discloses an n-type thermoelectric conversion material obtained by mixing and reacting at least one kind of material serving as the source of an element selected from Ta, Nb and V with a material serving as the source of Ti.

DISCLOSURE OF THE INVENTION

An object of the present invention is to provide a thermoelectric conversion material having a large output factor and a large figure of merit, a method for producing the thermoelectric conversion material, and a thermoelectric conversion device. The present inventors have studied and completed the present invention. More specifically, the present invention provides <1> to <10>.

<1> A thermoelectric conversion material comprising an oxide represented by formula (1):

$$M^1 O_y \qquad (1)$$

where $M^1$ is at least one selected from the group consisting of V, Nb and Ta, and

$$1.90 \leq y \leq 2.10.$$

<2> A thermoelectric conversion material comprising an oxide represented by formula (2):

$$M^1{}_{1-x} M^2{}_x O_y \qquad (2)$$

where $M^1$ is at least one selected from the group consisting of V, Nb and Ta, $M^2$ is at least one selected from the group consisting of Ti, Cr, Mn, Fe, Co, Zr, Hf, Mo and W,

$$0<x<0.5,$$

and

$$1.90\leq y\leq 2.10.$$

<3> The thermoelectric conversion material according to <1> or <2>, wherein the oxide has a rutile-type crystal structure.

<4> The thermoelectric conversion material according to <3>, wherein the lattice constant along the a-axis of the rutile-type crystal structure is not less than 0.4700 nm and not more than 0.4800 nm, and the lattice constant along the c-axis thereof is not less than 0.2980 nm and not more than 0.3200 nm.

<5> The thermoelectric conversion material according to any one of <1> to <4>, wherein $M^1$ is Nb.

<6> The thermoelectric conversion material according to any one of <1> to <5>, wherein the material is in form of a sintered body the relative density of the sintered body is not less than 60%.

<7> The thermoelectric conversion material according to <6>, wherein the surface of the sintered body is coated with an oxygen impermeable film.

<8> A thermoelectric conversion device comprising the thermoelectric conversion material described according to any one of <1> to <7>.

<9> A method for producing the thermoelectric conversion material according to <1>, comprising the steps of $a^1$ and $b^1$:

$a^1$: preparing a raw material containing $M^1$ (at least one selected from the group consisting of V, Nb and Ta) and O, the molar amount of O being not less than 1.90 and not more than 2.10 times the molar amount of $M^1$,

$b^1$: sintering a green body obtained by forming the raw material at a temperature of not less than 900°C and not more than 1700°C under an inert gas atmosphere.

<10> A method for producing the thermoelectric conversion material according to <2>, comprising the steps of $a^2$ and $b^2$:

$a^2$: preparing a raw material containing $M^1$ (at least one selected from the group consisting of V, Nb and Ta), $M^2$ (at least one selected from the group consisting of Ti, Cr, Mn, Fe, Co, Zr, Hf, Mo and W) and O, the molar amount of $M^2$ being more than 0 and less than 0.5 times the total molar amount of $M^1$ and $M^2$, the molar amount of O being not less than 1.90 and not more than 2.10 times the total molar amount of $M^1$ and $M^2$,

$b^2$: sintering a green body obtained by forming the raw material at a temperature of not less than 900°C and not more than 1700°C under an inert gas atmosphere.

BRIEF DESCRIPTION OF THE DRAWINGS

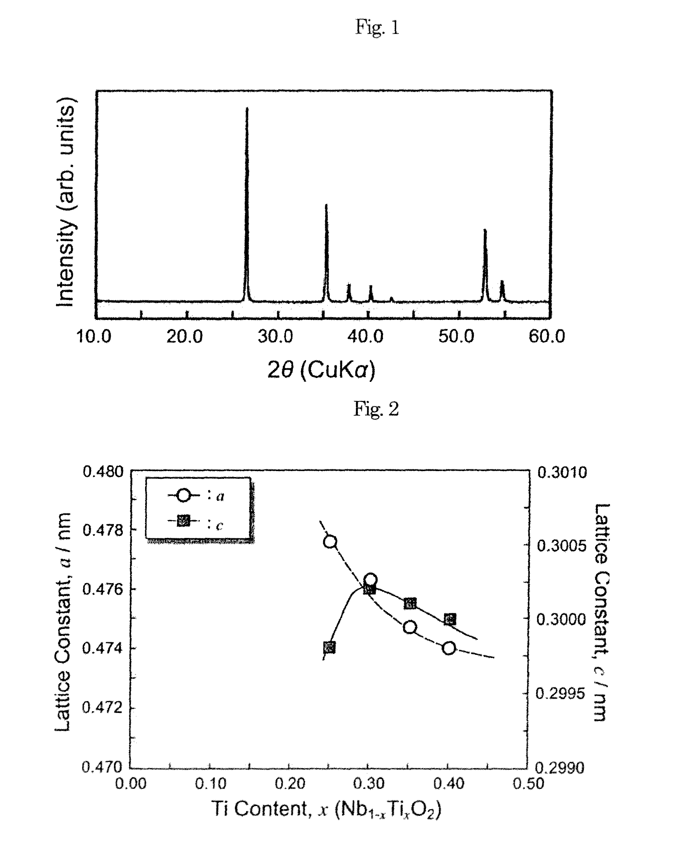

FIG. 1 is an X-ray diffraction pattern of sintered body 1;

FIG. 2 is a graph showing the relationship between the lattice constants (along the a-axis and the c-axis) of the thermoelectric conversion materials of sintered bodies 1 to 4 and molar ratio x;

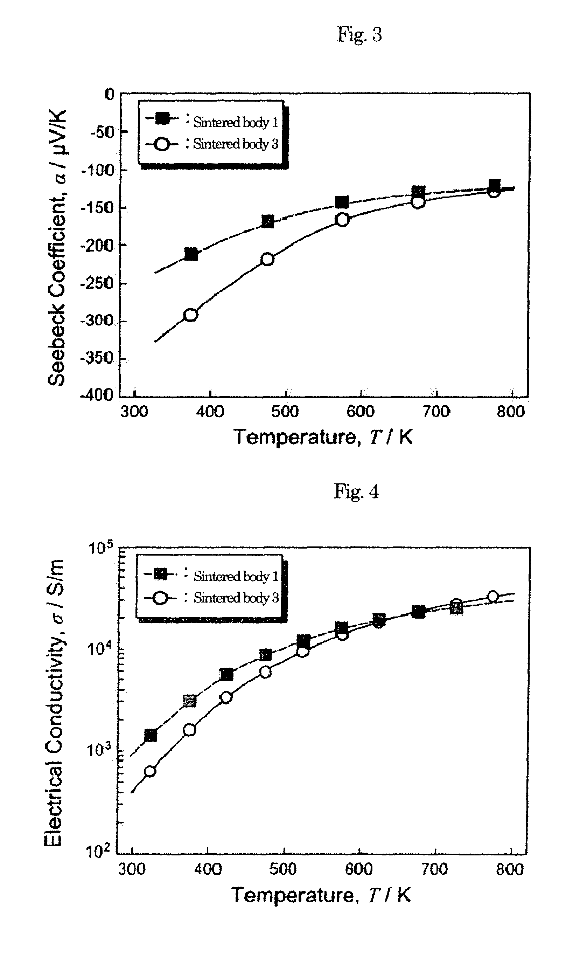

FIG. 3 is a graph showing changes in the Seebeck coefficients of sintered bodies 1 and 3 depending on temperature, T being absolute temperature (K);

FIG. 4 is a graph showing changes in the electric conductivities of sintered bodies 1 and 3 depending on temperature, T being absolute temperature (K);

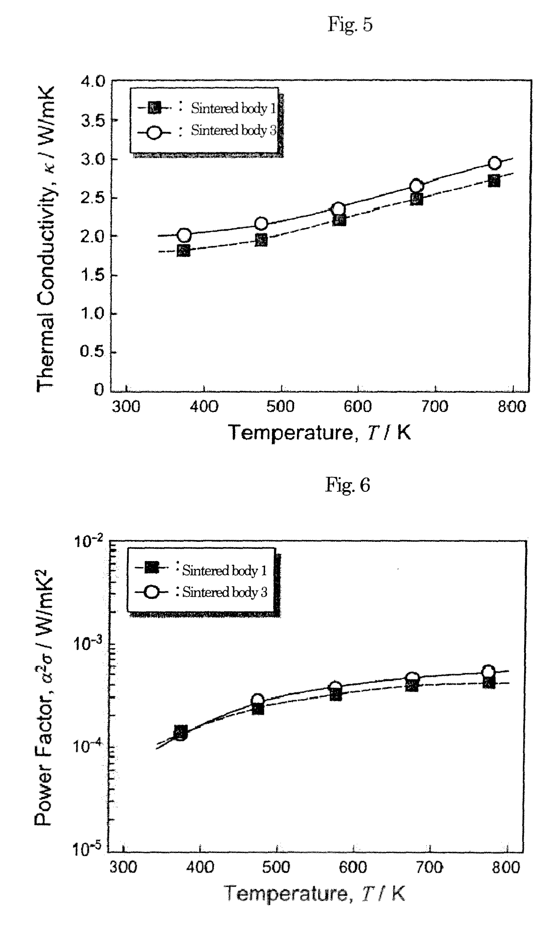

FIG. 5 is a graph showing changes in the thermal conductivities of sintered bodies 1 and 3 depending on temperature, T being absolute temperature (K);

FIG. 6 is a graph showing changes in the output factors of sintered bodies 1 and 3 depending on temperature, T being absolute temperature (K); and

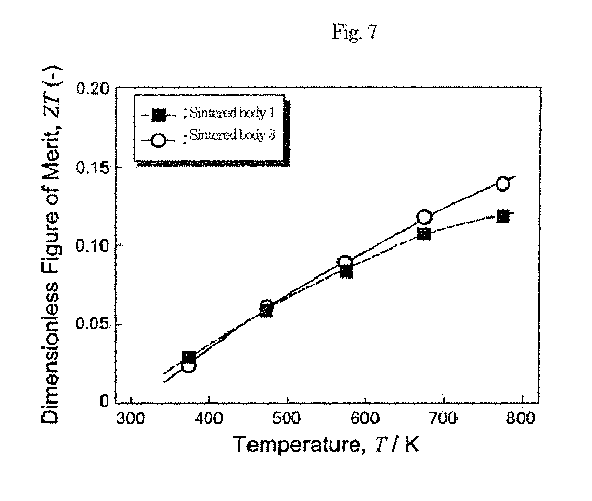

FIG. 7 is a graph showing changes in the non-dimensional figures of merit of sintered bodies 1 and 3 depending on temperature, T being absolute temperature (K).

## MODE FOR CURRYING OUT THE INVENTION

**Thermoelectric conversion material**

The thermoelectric conversion material according to the present invention comprises an oxide containing $M^1$ and oxygen (O).

$M^1$ is vanadium (V), niobium (Nb) or tantalum (Ta). Each of these may be used individually or in combination with another or more. To increase the output factor $\alpha^2 \times \sigma$, it is preferable that part or whole of $M^1$ is Nb, and it is further preferable that $M^1$ is Nb.

The oxide is represented by the above-mentioned formula (1).

In the formula (1), y is not less than 1.90, preferably not less than 1.95 and further preferably not less than 1.99, and not more than 2.10, preferably not more than 2.05 and further preferably not more than 2.02. When y is more than 2.10, impurity crystal phases (for example, $Nb_2O_5$, etc. $M^1$ is Nb) are produced, whereby the electric conductivity $\sigma$ tends to be smaller and the Output factor $\alpha^2 \times \sigma$ is not sufficient. On the other hand, when y is less than 1.90, impurity crystal phases (for example, $NbO_{1.1}$, etc. $M^1$ is Nb) are produced, whereby the Seebeck coefficient $\alpha$ tends to be smaller and the output factor $\alpha^2 \times \sigma$ is not sufficient.

Furthermore, the oxide may further contain $M^2$. The oxide is represented by the above-mentioned formula (2).

$M^2$ is titanium (Ti), chromium (Cr), manganese (Mn), iron (Fe), cobalt (Co), zirconium (Zr), hafnium (Hf), molybdenum (Mo) or tungsten (W). Each of these may be used individually or in combination with another or more. To improve the output factor $\alpha^2 \times \sigma$, it is preferable that part or whole of $M^2$ is Ti, and it is further preferable that $M^2$ is Ti.

In the formula (2), x is more than 0, preferably not less than 0.20 and further preferably not less than 0.25, and less than 0.5. y is not less than 1.90, preferably not less than 1.95 and further preferably not less than 1.99, and not more than 2.10, preferably not more than 2.05 and further preferably not more than 2.02. When y is more than 2.10, impurity crystal phases (for example, $TiNb_2C_7$, $Nb_2O_5$, etc. $M^1$ is No and $M^2$ is Ti) are produced, whereby the electric conductivity $\sigma$ tends to be smaller and the output factor $\alpha^2 \times \sigma$ is not sufficient. On the other hand, when y is less than 1.90, impurity crystal phases (for example, $NbO_{1.1}$, $Ti_nO_{2n-1}$, etc. $M^1$ is Nb and $M^2$ is Ti) are produced, the Seebeck coefficient $\alpha$ tends to be smaller, and the output factor $\alpha^2 \times \sigma$ is not sufficient.

The oxide has the crystal structure of a rutile type, an anatase type or a brookite type. It is preferable that the oxide contains a rutile-type crystal structure, and it is further preferable that the oxide is in the form of a rutile-type crystal structure. When the oxide has the crystal structure of a rutile type, the oxide has an excellent energy conversion efficiency even though the oxide is used at high temperatures. It is thus possible to obtain a thermoelectric conversion device that is hardly degraded even after long-term use.

When the oxide has a rutile-type crystal structure, the rutile-type crystal structure has a lattice constant along the a-axis of not less than 0.4700 nm and not more than 0.4800 nm, and a lattice constant along the c-axis of not less than 0.2980 nm and not more than 0.3200 nm. For example, when $M^1$ is Nb, it is preferable that the the rutile-type crystal structure has a lattice constant along the a-axis of not less than 0.4730 nm and not more than 0.4780 nm, and a lattice constant along the c-axis of not less than 0.2990 nm and not more than 0.3100 nm. The thermoelectric conversion material having the lattice constant along the a-axis and the lattice constant along the c-axis each falling within the above-mentioned ranges tends to have a larger output factor and a lower thermal conductivity. The lattice constants of the rutile-hype crystal structure may be determined by identifying the peaks of the X-ray diffraction of the rutile-type crystal structure by using an X-ray diffraction pattern measured by X-ray diffraction at room temperature and by calculating the lattice constants from the values at the peak positions ($2\theta$) using the least square method (for example, refer to "Crystal Analysis, Universal Program System (II)" edited by Toshio Sakurai, published by the Crystallographic Society of Japan, 1967).

A thermoelectric conversion material is usually in the form of powder, a sintered body, a thin film or a single crystal, preferably a sintered body. When a thermoelectric conversion material is in the form of a sintered body, the shape and size of the thermoelectric conversion material may be suitably adjusted for a thermoelectric conversion device. For example, the thermoelectric conversion material has the shape of a plate, a cylinder, a disc or a prism.

A thermoelectric conversion material in the form of a sintered body has a relative density of usually not less than 60%, preferably not less than 80%, further preferably not less than 85%, to ensure strength. The thermoelectric conversion material with a relative density of less than 60% tends to have a decreased electric conductivity $\sigma$.

## METHOD FOR PRODUCING THERMOELECTRIC CONVERSION MATERIAL

A thermoelectric conversion material may be produced by using a method of heating a raw material of the thermoelectric conversion material. A thermoelectric conversion material in the shape of a sintered body may be produced by using a method in which the raw material thereof are formed into a green body and the green body is sintered. The thermoelectric conversion material represented by the above-mentioned formula (1) may be produced, for example, by using the method comprising the steps of $a^1$ and $b^1$.

$a^1$: preparing a raw material containing $M^1$ (at least one selected from the group consisting of V, Nb and Ta) and oxygen (O), the molar amount of O being not less than 1.90 and not more than 2.10 times the molar amount of $M^1$,
$b^1$: sintering a green body obtained by forming the raw material at a temperature of not less than 900°C and not more than 1700°C under an inert gas atmosphere.

The thermoelectric conversion material represented by the above-mentioned formula (2) be produced by using the method comprising the steps of $a^2$ and $b^2$.

$a^2$: preparing a raw material containing $M^1$ (at least one selected from the group consisting of V, Nb and Ta), $M^2$ (at least one selected from the group consisting of Ti, Cr, Mn, Fe, Co, Zr, Hf, Mo and W) and O, the molar amount of $M^2$ being more than 0 and less than 0.5 times the total molar amount of $M^1$ and $M^2$, and the molar amount of O being not less than 1.90 and not more than 2.10 times the total molar amount of $M^1$ and $M^2$,
$b^2$: sintering a green body obtained by forming the raw material at a temperature of not less than 900°C and not more than 1700°C under an inert gas atmosphere.

[Starting material]

At step $a^1$ and step $a^2$, starting materials containing the metal element ($M^1$ or $M^2$) is weighed and mixed to obtain a mixture so that the mixture has a predetermined composition, whereby a mixture is obtained in which the molar amount of O is not less than 1.90 and not more than 2.10 times the total molar amount of $M^1$ and $M^2$. Examples of the starting materials containing $M^1$ include an oxide, such as $Nb_2O_5$, $Ta_2O_5$ or $V_2O_5$, or a metal, such as Nb, Ta or V. Each of these may be used individually or in combination with another or more. Examples of the starting material containing $M^2$ include an oxide, such as $TiO_2$, $Ti_2O_3$, $TiO$, $Cr_2O_3$, $MnO_2$, $Fe_2O_3$, $Fe_3O_4$, $FeO$, $CO_3O_4$, $CoO$, $ZrO_2$, $HfO_2$, $MoO_3$ or $WO_3$, or a metal, such as Ti, Cr, Mn, Fe, Co, Zr, Hf, Mo or W. Each of these may be used individually or in combination with another or more. Furthermore, when pre-calcination or calcination described later is performed, instead of the above-mentioned oxides and metals, substances that can be decomposed and/or oxidized to oxides at high temperatures, such as hydroxides, carbonates, nitrates, halides or organic acid salts of the metal element ($M^1$ or $M^2$) may also be used as the starting material containing the metal element ($M^1$ or $M^2$).

[Mixing]

Mixing may be performed using a dry method or a wet method. It is preferable that the mixing is performed by using a method in which a mixture uniformly containing metal elements is obtained. The mixing may be performed with a ball mill, a V-type mixer, a vibrating mill, an attritor, a dyno mill or a dynamic mill.
For producing a thermoelectric conversion material comprising an oxide represented by formula $Nb_{0.06}Ti_{0.40}O_{2.00}$, one of favorable compositions, $Nb_2O_5$, $TiO_2$ and Ti may be weighed and mixed to obtain a mixture so that the molar ratio of Nb, Ti and O is 0.60:0.40:2.00, and mixture may be used as a raw material. In addition, for producing a thermoelectric conversion material comprising an oxide represented by formula $Nb_{1.00}O_{2.00}$, $Nb_2O_5$ and Nb may be weighed and mixed to obtain a mixture so that the molar ratio of Nb and O is 1.00:2.00, and the mixture may be used as a raw material.

[Pre-calcination]

When the mixture contains hydroxides, carbonates, nitrates, halides or organic acid salts, the mixture may be pre-calcined under an inert gas atmosphere or oxidized gas atmosphere before calcination to remove carbon dioxide, crystal water, etc. A pre-calcination temperature is usually not less than approximately 300°C and not more than a calcination temperature described later, for example, not more than approximately 600°C.

[Calcination]

When the mixture (or pre-calcined mixture) has a molar amount of O of more than 2.10 times the total molar amount of $M^1$ and $M^2$, the mixture may be calcined under a reducing gas atmosphere and used as a raw material. On the other hand, when the mixture) (or pre-calcined mixture) has a molar amount of O of less than 1.90 times the total molar amounts of $M^1$ and $M^2$, the mixture may be calcined under an oxidized gas atmosphere and used as a raw materials. While the mixture (or pre-calcined mixture) has a molar amount of O of not less than 1.90 and not more than 2.10 times the total molar amount of $M^1$ and $M^2$, calcining the mixture under an inert gas atmosphere can reduce deformation during sintering in some cases. Calcination conditions depends on the composition, and a calcination temperature is usually not less than approximately 600°C and not more than approximately 1100°C and a calcination time is usually 0.5 to 24 hours. When the mixture contains hydroxides, carbonates, nitrates, halides or organic acid salts, it is possible to remove carbon dioxide gas, crystal water, etc. by calcination. The calcined mixture may be pulverized and used as a raw material. The pulverization may be performed with, for example, a ball mill, a vibrating mill, an attritor, a dyno mill or a dynamic mill. Furthermore, the mixture may be calcined after it is formed. Using the calcined mixture as a raw material can improve the uniformity of the composition of the sintered body and the uniformity of the structure thereof and reduce the deformation of the sintered body in some times.

[Forming]

Forking be performed with, for example, a uniaxial press, a cold isostatic press (CIP), a mechanical press, a hot press or a hot isostatic press (HIP). A binder, a dispersing agent and a releasing agent may be used for forming. A green body may have a shape suitable for a thermoelectric conversion device. Examples of the shape include a plate, a cylinder, a disc and a prism.

[Sintering]

Sintering temperature is usually not less than 900°C, preferably not less than 1200°C, further preferably not less than 1250°C and usually not more than 1700°C, preferably not more than 1600°C, further preferably not more than 1500°C. When the sintering temperature is less than 900°C, a solid phase reaction and sintering do not proceed in some cases, and the electric conductivity σ becomes lower depending on the composition in some cases. When the sintering temperature is more than 1700°C, the desired oxide is not obtained because the constituent elements melt and volatilize depending on the composition in some cases, and the thermoelectric conversion material has the reduced figure of merit Z in some cases. When calcination is performed before sintering, the sintering may be performed under an inert gas atmosphere at a temperature higher than the above-mentioned calcination temperature and not higher than 1700°C. The sintering time is usually approximately 0.5 to 24 hours. The inert gas atmosphere during the sintering is, for example, a nitrogen atmosphere or a rare gas atmosphere, preferably an atmosphere containing a rare gas, further preferably a rare gas atmosphere. Ar is used preferably as a rare gas from the viewpoint of operability. The forming and the sintering may be performed simultaneously. In this case, a hot press or a hot isostatic press (HIP) may be used.

Furthermore, the sintered body may be pulverized, re-sintered and used as a thermoelectric conversion material. The re-sintering may be performed under the same conditions as those of the above-mentioned sintering.

According to the above-mentioned production method, a thermoelectric conversion material in the form of a sintered body is obtained. The sintered body has a relative density of usually not less than 60%, preferably not less than 80%, further preferably not less than 85%. The relative density of the sintered body can be adjusted depending on the particle size of the material thereof before the sintering, forming pressure, sintering temperature, sintering time, etc.

Moreover, the sintered body may be coated with an oxygen impermeable film, through the surface of which oxygen hardly passes. The coating can reduce performance degradation to which surface oxidation leads in the thermoelectric conversion material. The oxygen impermeable film is formed of alumina, titania, zirconia, silicas silicon carbide, etc. The coating may be performed using, for example, an aerosol deposition, a spraying or a CVD (chemical vapor deposition).

The thermoelectric conversion material may be produced by a method comprising a coprecipitation step, a method comprising a hydrothermal step, a method comprising a dry-up step, a method comprising a sputtering step, a method comprising a step in which CVD is performed, a method comprising a sol-gel step, a method comprising an FZ (floating zone melting) step or a method comprising a TSCG (template single crystal growing method) in addition to the above-mentioned method.

**THERMOELECTRIC CONVERSION DEVICE**

A thermoelectric conversion device comprises the above-mentioned thermoelectric conversion material.

Since the thermoelectric conversion material is usually an n-type, the thermoelectric conversion device comprises a p-type thermoelectric conversion material, an n-electrode and a p-electrode in addition to the above-mentioned n-type thermoelectric conversion material. As the p-type thermoelectric conversion material, four example, $NaCo_2O_4$ or $Ca_3Co_4O9$ may be used (JP-A-9-321346 and JP-A-2001-64021). The thermoelectric conversion device may be produced so as to have the structure disclosed, for example, in JP-A-5-315657.

<u>EXAMPLES</u>

The present invention will be illustrated in further detail with reference to Examples. The properties and structure of a thermoelectric conversion material are determined by using the methods described below.

1. Electric conductivity σ (S/m)

A sintered body sample was formed to be in the shape of a prism, platinum wires were attached using silver paste, and the electric conductivity was measured using a direct current four-terminal method. The measurement was performed while the temperature was changed in the range of from room temperature to 500°C under nitrogen gas stream.

2. Seebeck coefficient α (μV/K)

R thermocouple wires and platinum wires were attached across both ends of a sample formed to be in the shape of a prism as in the measurement of electric conductivity, and the temperature and the thermoelectromotive force of the sample were measured. The measurements were performed while the temperature was changed in the range of from room temperature to 500°C under nitrogen gas stream. One side of the sample was cooled using a cooling pipe to form a low-temperature portion. The temperatures at both ends of the sample were measured, and the thermoelectromotive force ΔV generated across both end faces of the sample was also measured. The temperature difference ΔT across both ends of the sample was adjusted in the range of from 0.5 to 10°C by adjusting the temperature of the low-temperature portion, and the Seebeck coefficient α was calculated from the slopes of ΔT and ΔV.

3. Thermal conductivity (W/mK)

The specific heat and the thermal diffusion factor of a sintered body sample were measured using the laser flash method in vacuum while the temperature was changed in the range of from room temperature to 500°C. A laser thermal constants measuring system TC-7000 manufactured by ULVAC-RIKO, Inc used.

4. Structure and composition analysis

The crystal structures of a powder sample and a sintered body sample were analyzed with an X-ray diffractometer RINT2500TTR manufactured by RIGAKU Co., Ltd. using the powder X-ray diffraction in which Cubα is used as a radiation source. The lattice constants (along the a-axis and the c-axis) of the rutile-type crystal structure of the sample were determined by identifying the peaks of the X-ray diffraction of the rutile-type crystal structure by using an X-ray diffraction pattern measured by X-ray diffraction and by calculating the lattice constants from the values at the peak positions 2θ using the least square method. The composition of the metal elements in the sample were measured with an X-ray fluorescence spectrometer PW1480 manufactured by Philips Inc. Furthermore, with respect to the amount of oxygen contained in the sample, the increase in weight at the time when the sample was heat treated at a temperature of not less than 1000°C and not more than 1200°C for 48 hours in the atmosphere was wholly calculated as the increased amount of oxygen.

5. Relative density (%)

The density of a sintered body sample was measured using the Archimedes' method. The relative density was calculated on the basis of the density and the lattice constant data determined using the powder X-ray diffraction.

Example 1

Niobium oxide ($Nb_2O_5$ manufactured by KOJUNDO CHEMICAL LABORATORY CO., LTD.), titanium oxide ($TiO_2$ manufactured by ISHIHARA TECHNO CORPORATION, Trade name: PT-401M) and titanium metal (Ti manufactured by KOJUNDO CHEMICAL LABORATORY CO., LTD.) were used as starting materials. The niobium oxide, titanium oxide and titanium metal were weighed (Table 1) and mixed with a dry ball mill (media: plastic balls) for 6 hours to obtain a mixture of Nb, Ti and O in the ratio of Nb:Ti:O = 0.60:0.40:2.00 (in the molar ratio of $Nb_2O_5$:$TiO_2$:Ti = 0.300:0.250: 0.150). The mixture was formed into the shape of a disc using a uniaxial press (forming pressure: 200 kg/cm$^2$) and calcined at 1000°C for 3 hours under an argon atmosphere (purity: 99.9995%) to obtain a calcined mixture. The calcined mixture was pulverized using a dry method with a ball mill (media: zirconia balls) to obtain a pulverized mixture (raw material). The raw material was formed into the shape of disc with a uniaxial press (forming pressure: 200 kg/cm$^2$) to obtain a green body. The green body was sintered at 1300°C for 6 hours under an argon atmosphere (purity: 99.9995%) with a sintering furnace to obtain sintered body 1.

The composition, lattice constants and relative density of sintered body 1 were shown in Table 2. The sintered body 1 had the crystal structure of a rutile type, a lattice constants along the a-axis of 0.4740 nm, and a lattice constants along the c-axis of 0.2998 nm. The sintered body 1 had the color of black and a relative density of 95.5%.

The Seebeck coefficient $\alpha$, the electric conductivity $\sigma$, the thermal conductivity $\kappa$, the output factor $\alpha^2 \times \sigma$ and the non-dimensional figure of merit ZT of sintered body 1 at 500°C were shown in Table 3. The non-dimensional figure of merit is calculated by multiplying the figure of merit Z ($K^{-1}$) by absolute temperature T(K).

Examples 2 to 4 (production of sintered bodies 2 to 4)

Except that the amounts of the starting materials were changed as shown in Table 1, the same procedures as in Example 1 was performed to obtain sintered bodies 2 to 4. The properties of sintered bodies 2 to 4 were shown in Tablets 2 and 3. All of sintered bodies 2 to 4 had the crystal structures of a rutile type.

Example 5 (production of sintered body 5)

Except that the amounts of the starting materials were changed as shown in Table 1, the same procedures as in Example 1 was performed to obtain sintered body 5. The properties of sintered body 5 were shown in Tables 2 and 3. Sintered body 5 had the crystal structure of nearly a rutile type.

Table 1

| Sintered body | Materials and their amounts (molar ratio) | | | $Nb_{1-x}Ti_xO_y$ at the time of weighing | |
|---|---|---|---|---|---|
| | $Nb_2O_5$ | $TiO_2$ | Ti | x | y |
| Sintered body 1 | 0.3000 | 0.2500 | 0.1500 | 0.40 | 2.00 |
| Sintered body 2 | 0.3250 | 0.1875 | 0.1625 | 0.35 | 2.00 |
| Sintered body 3 | 0.3500 | 0.1250 | 0.1750 | 0.30 | 2.00 |
| Sintered body 4 | 0.3750 | 0.0625 | 0.1875 | 0.25 | 2.00 |
| Sintered body 5 | 0.6000 | 0.2000 | 0.2000 | 0.40 | 1.90 |

Table 2

| Sintered body | Result of composition analysis $Nb_{1-x}Ti_xO_y$ | | Lattice constants (nm) | | Relative density % |
|---|---|---|---|---|---|
| | x | y | a-axis | c-axis | |
| Sintered body 1 | 0.40 | 1.99 | 0.4740 | 0.2998 | 95.5 |
| Sintered body 2 | 0.35 | 2.00 | 0.4747 | 0.3002 | 91.7 |
| Sintered body 3 | 0.30 | 2.01 | 0.4763 | 0.3001 | 97.8 |
| Sintered body 4 | 0.25 | 2.02 | 0.4776 | 0.3000 | 96.8 |
| Sintered body 5 | 0.40 | 1.93 | 0.4737 | 0.2999 | 79.6 |

Table 3

| Sintered body | Seebeck coefficient | Electric conductivity | Thermal conductivity | Output factor | Non-dimensional figure of merit |
|---|---|---|---|---|---|
| | $\alpha$ ($\mu$V/K) | $\sigma$ (S/m) | $\kappa$ (W/mK) | $\alpha^2\sigma$ (W/mK$^2$) | ZT (-) |
| Sintered body 1 | -122 | $2.77\times10^4$ | 2.71 | $4.15\times10^{-4}$ | 0.118 |
| Sintered body 2 | -120 | $3.02\times10^4$ | 2.68 | $4.34\times10^{-4}$ | 0.125 |
| Sintered body 3 | -128 | $3.24\times10^4$ | 2.94 | $5.29\times10^{-4}$ | 0.139 |
| Sintered body 4 | -115 | $2.92\times10^4$ | 2.79 | $3.83\times10^{-4}$ | 0.106 |
| Sintered body 5 | -114 | $2.25\times10^4$ | 2.10 | $2.90\times10^{-4}$ | 0.107 |

Comparative examples 1 to 3 (production of sintered bodies 6 to 8)

Except that the amounts of the starting materials were changed as shown in Table 4, the same procedures as in Example 1 was performed to obtain sintered bodies 6-8. The properties of sintered bodies 6 to 8 were shown in Tables 5 and 6. All of sintered bodies 6 to 8 had two phases having different crystal structured, $Nb_{1-x}Ti_xO_2$ and $TiNb_2O_7$, each of which had a rutile-type crystal structure, and had lower density.

Table 4

| Sintered body | Materials and their amounts (molar ratio) | | | $Nb_{1-x}Ti_xO_y$ at the time of weighing | |
|---|---|---|---|---|---|
| | $Nb_2O_5$ | $TiO_2$ | Ti | x | y |
| Sintered body 6 | 0.0500 | 0.9000 | 0.0000 | 0.90 | 2.05 |
| Sintered body 7 | 0.0750 | 0.8500 | 0.0000 | 0.85 | 2.08 |
| Sintered body 8 | 0.1000 | 0.8000 | 0.0000 | 0.80 | 2.10 |

Table 5

| Sintered body | Result of composition analysis $Nb_{1-x}Ti_xO_y$ | |
|---|---|---|
| | x | y |
| Sintered body 6 | 0.90 | 2.03 |
| Sintered body 7 | 0.85 | 2.06 |
| Sintered body 8 | 0.80 | 2.08 |

Table 6

| Sintered body | Seebeck coefficient | Electric conductivity | Thermal conductivity | Output factor | Non-dimensional figure of merit |
|---|---|---|---|---|---|
| | $\alpha$ ($\mu$V/K) | $\sigma$ (S/m) | $\kappa$ (W/mK) | $\alpha^2\sigma$ (W/mK$^2$) | ZT (-) |
| Sintered body 6 | -288 | $1.11\times10^3$ | 1.52 | $9.21\times10^{-5}$ | 0.047 |
| Sintered body 7 | -500 | $3.78\times10^2$ | 1.97 | $9.44\times10^{-5}$ | 0.037 |
| Sintered body 8 | -349 | $1.82\times10^2$ | 2.18 | $2.22\times10^{-5}$ | 0.008 |

INDUSTRIAL APPLICABILITY

According to the present invention, a thermoelectric conversion material having a large output factor $\alpha^2\times\sigma$ and

a large figure of merit Z is obtained.

**Claims**

1. A thermoelectric conversion material comprising an oxide represented by formula (1):

$$M^1O_y \qquad (1)$$

   where $M^1$ is at least one selected from the group consisting of V, Nb and Ta, and $1.90 \leq y \leq 2.10$.

2. A thermoelectric conversion material comprising an oxide represented by formula (2):

$$M^1_{1-x}M^2_xO_y \qquad (2)$$

   where $M^1$ is at least one selected from the group consisting of V, Nb and Ta, $M^2$ is at least one selected from the group consisting of Ti, Cr, Mn, Fe, Co, Zr, Hf, Mo and W,
   $0<x<0.5$, and $1.90 \leq y \leq 2.10$.

3. The thermoelectric conversion material according to claim 1 or 2, wherein the oxide has a rutile-type crystal structure.

4. The thermoelectric conversion material according to claim 3, wherein the lattice constant along the a-axis of the rutile-type crystal structure is not less than 0.4700 nm and not more than 0.4800 nm, and the lattice constant along the c-axis thereof is not less than 0.2980 nm and not more than 0.3200 nm.

5. The thermoelectric conversion material, according to any one of claims 1 to 4, wherein $M^1$ is Nb.

6. The thermoelectric conversion material according to any one of claims 1 to 5, wherein the material is in the form of a sintered body and the relative density of the sintered body is not less than 60%.

7. The thermoelectric conversion material according to claim 6, wherein the surface of the sintered body is coated with an oxygen impermeable film.

8. A thermoelectric conversion device having said thermoelectric conversion material according to any one of claims 1 to 7.

9. A method for producing said thermoelectric conversion material according to claim 1, comprising the steps of $a^1$ and $b^1$.

   $a^1$: preparing a raw material containing $M^1$ (at least one selected from the group consisting of V, Nb and Ta) and O, the molar amount of O being not less than 1.90 and not more than 2.10 times the molar amount of $M^1$,
   $b^1$: sintering a green body obtained by forming the raw material at a temperature of not less than 900°C and not more than 1700°C under an inert gas atmosphere.

10. A method for producing said thermoelectric conversion material according to claim 2, comprising the step of $a^2$ and $b^2$,

   $a^2$: preparing a raw material containing $M^1$ (at least one selected from the group consisting of V, Nb and Ta), $M^2$ (at least one selected from the group consisting of Ti, Cr, Mn, Fe, Co, Zr, Hf, Mo and W) and O, the molar amount of $M^2$ being more than 0 and less than 0.5 times the total molar amount of $M^1$ and $M^2$, and the molar amount of O being not less than 1.90 and not more than 2.10 times the total molar amount of $M^1$ and $M^2$,
   $b^2$: sintering a green body obtained by forming the raw material at a temperature of not less than 900°C and not more than 1700°C under an inert gas atmosphere.

Fig. 1

Fig. 2

Fig. 3

Fig. 4

Fig. 5

Fig. 6

Fig. 7

## INTERNATIONAL SEARCH REPORT

| International application No. |
|---|
| PCT/JP2008/057457 |

A. CLASSIFICATION OF SUBJECT MATTER
*H01L35/22*(2006.01)i, *C01G33/00*(2006.01)i, *C04B35/00*(2006.01)i, *C04B41/87*(2006.01)i, *H01L35/34*(2006.01)i

According to International Patent Classification (IPC) or to both national classification and IPC

B. FIELDS SEARCHED

Minimum documentation searched (classification system followed by classification symbols)
H01L35/22, C01G33/00, C04B35/00, C04B41/87, H01L35/34

Documentation searched other than minimum documentation to the extent that such documents are included in the fields searched
Jitsuyo Shinan Koho          1922-1996    Jitsuyo Shinan Toroku Koho    1996-2008
Kokai Jitsuyo Shinan Koho    1971-2008    Toroku Jitsuyo Shinan Koho    1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | B.FISHER, ELECTRICAL AND SEEBECK EFFECT MEASUREMENTS IN Nb DOPED VO2, THE JOURNAL OF PHYSICS AND CHEMISTRY OF SOLIDS, 08 March, 1982 (08.03.82), (received date), VOLUME 43, NUMBER 3, pages 205 to 211 | 1-2,10 |
| X | F.LAGNEL, B.POUMELLEC, and C.PICARD, Electron Transport in Amorphous (Ti, Nb)O2 Solid Solutions, Physica status solidi(b), 1989.02, Volume 151, Number 2, pages 531 to 543 | 1-2,10 |
| X | Yasuaki KITAMURA, "MA/HP-ho ni yori Sakusei shita Ti1-xNbxO2 no Netsuden Tokusei", The Japan Institute of Metals Koen Gaiyo Collected Abstracts of the 2007 Spring Meeting of the Japan Institute Metals, 27 March, 2007 (27.03.07), 140th, page 352 | 1-2,10 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 July, 2008 (07.07.08) | 15 July, 2008 (15.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/057457

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2005-276959 A  (National Institute of Advanced Industrial Science and Technology), 06 October, 2005 (06.10.05), Full text (Family: none) | 1-2,10 |
| A | JP 2006-062951 A  (Sumitomo Chemical Co., Ltd.), 09 March, 2006 (09.03.06), Full text & US 2007/0157961 A1    & EP 1791191 A1 & WO 2006/011581 A1    & CN 1989631 A & KR 20070048734 A | 1-2,10 |
| A | JP 2006-100683 A  (Sumitomo Kinzoku Kabushiki Kaisha), 13 April, 2006 (13.04.06), Full text & US 2007/0157961 A1    & EP 1791191 A1 & WO 2006/011581 A1    & KR 20070048734 A | 1-2,10 |
| P,A | WO 2008/023650 A1  (Sumitomo Chemical Co., Ltd.), 28 February, 2008 (28.02.08), Full text (Family: none) | 1-2,10 |

Form PCT/ISA/210 (continuation of second sheet) (April 2007)

## INTERNATIONAL SEARCH REPORT

International application No.

PCT/JP2008/057457

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
   See extra sheet.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
   1-2, 10

**Remark on Protest**       ☐ The additional search fees were accompanied by the applicant's protest and, where applicable,
the                                      payment of a protest fee.

                                 ☐ The additional search fees were accompanied by the applicant's protest but the applicable protest
                                    fee was not paid within the time limit specified in the invitation.

                                 ☐ No protest accompanied the payment of additional search fees.

Form PCT/ISA/210 (continuation of first sheet (2)) (April 2007)

**INTERNATIONAL SEARCH REPORT**

International application No.

PCT/JP2008/057457

Continuation of Box No.III of continuation of first sheet(2)

Where a group of inventions is claimed in one and the same international application, the requirement of unity of invention (PCT Rule 13.1) shall be fulfilled only when there is a technical relationship among those inventions involving one or more of the same or corresponding special technical features (i.e., technical features which define a contribution which each of the inventions, considered as a whole, makes over the prior art), as set forth in PCT Rule 13.2.

In the present case, a common technical feature between the invention of claim 1 and the inventions of claims 2-10 resides in a matter described in claim 1.

On the other hand, the invention of claim 1 of the present application is disclosed in Document 1: B. FISHER, ELECTRICAL AND SEEBECK EFFECT MEASUREMENTS IN Nb DOPED VO2, THE JOURNAL OF PHYSICS AND CHEMISTRY OF SOLIDS, 1982.03.08 (receiving date), VOLUME 43, NUMBER 3, PP.205-211; Document 2: F.LAGNEL, B.POUMELLEC, and C.PICARD, Electron Transport in Amorphous (Ti, Nb) 02 Solid Solutions, Physica status solidi(b), 1989.02, Volume 151, Number 2, 531-543; and Document 3: Yasuaki KITAMURA, "MA/HP-ho ni yori Sakusei shita Ti1-xNbxO2 no Netsuden Tokusei", The Japan Institute of Metals Koen Gaiyo, Collected Abstracts of the 2007 Spring Meeting of the Japan Institute Metals, 2007, 03, 27, 140th, p.352.

Therefore, the matter is considered to be a technical feature which is already known at the time of filing the present international application. Thus, the matter cannot be regarded as a technique that makes any contribution over the prior art, and cannot be regarded as a special technical feature as defined in the above-mentioned rule.

Further, there is found no other same or corresponding special technical feature between the inventions.

For the reasons stated above, in the present application, it cannot be considered that there is the same or corresponding special technical features between the above-mentioned inventions, and the inventions of claims of the present international application do not comply with the requirement of unity of invention as defined in PCT Rule 13.1.

Form PCT/ISA/210 (extra sheet) (April 2007)

## REFERENCES CITED IN THE DESCRIPTION

**Patent documents cited in the description**

- JP 2005276959 A
- JP 9321346 A
- JP 2001064021 A
- JP 5315657 A

**Non-patent literature cited in the description**

- Crystal Analysis, Universal Program System (II). the Crystallographic Society of Japan, 1967